# EUROPÄISCHE PATENTANMELDUNG

(11) **EP 4 704 344 A1**
(43) Veröffentlichungstag der Anmeldung: **04.03.2026**
(21) Anmeldenummer: 24197618.2
(22) Anmeldetag: 30.08.2024
(51) Int. Cl.: H03K 17/96, E03C 1/22

(54) **VERFAHREN UND VORRICHTUNG ZUM BETÄTIGEN EINES ELEKTRISCH BETRIEBENEN SPÜLBECKENABLAUFS**

(71) Anmelder: Kurr Holding GmbH & Co. KG, 63843 Niedernberg (DE)
(72) Erfinder: Stoschek, Bernd, 63699 Kefenrod (DE); Santinon, Roberto, 31011 Casella d'Asolo (TV) (IT); Maier, Oliver, 67549 Worms (DE)
(74) Vertreter: Habermann Intellectual Property Partnerschaft von Patentanwälten mbB

(57) **Zusammenfassung**

Bei einem Verfahren zum Betätigen eines elektrisch betriebenen Spülbeckenablaufs (11) wird in einem Auswerteschritt in einem Auslöseschritt überprüft, ob eine erste Veränderung der erfassten Kapazitätskenngröße (16) ein vorgegebenes Auslösekriterium erfüllt. In diesem Fall wird in einem dem Auslöseschritt nachfolgenden Bestätigungsschritt ein erstes Bestätigungszeitfenster (20) vorgegeben und überprüft, ob innerhalb des ersten Bestätigungszeitfensters (20) eine zweite Veränderung der erfassten Kapazitätskenngröße (16) ein erstes Bestätigungskriterium erfüllt. Ein Ablaufbetätigungskriterium ist nur dann erfüllt und der elektrisch betriebene Spülbeckenablauf (11) wird nur dann betätigt, wenn die innerhalb des ersten Bestätigungszeitfensters (20) erfasste zweite Veränderung der erfassten Kapazitätskenngröße (16) das erste Bestätigungskriterium erfüllt.

## Beschreibung

Die Erfindung betrifft ein Verfahren zum Betätigen eines elektrisch betriebenen Spülbeckenablaufs, wobei in einem Auswerteschritt mit einem kapazitiven Sensor mehrfach nacheinander Kapazitätskenngrößen erfasst werden und mit einer Auswerteeinrichtung überprüft wird, ob die erfassten Kapazitätskenngrößen ein vorgegebenes Ablaufbetätigungskriterium erfüllen, um anschließend in einem Betätigungsschritt eine Betätigung des elektrisch betriebenen Spülbeckenablaufs durchzuführen. Die Erfindung betrifft auch eine Vorrichtung zum Betätigen eines elektrisch betriebenen Spülbeckenablaufs, wobei die Vorrichtung eine Sensoreinrichtung mit mindestens einem kapazitiven Sensor für die Erfassung mindestens einer Kapazitätskenngröße, eine Auswerteeinrichtung für die Auswertung der mit der Sensoreinrichtung erfassten Kapazitätskenngrößen und eine Betätigungseinrichtung für den elektrischen Betrieb des Spülbeckenablaufs aufweist.

Ein betätigbarer Spülbeckenablauf weist üblicherweise ein Ablaufventil mit einem Stopfen oder einer Abdeckung auf, wobei durch eine geeignete Betätigung der Stopfen oder die Abdeckung zwischen einer Verschlussposition, in welcher das Ablaufventil verschlossen ist und Wasser in dem Spülbecken zurückgehalten wird, und einer Öffnungsposition verlagert werden kann, in welcher das Ablaufventil geöffnet ist und Wasser aus dem Spülbecken ablaufen kann. Der Stopfen oder die Abdeckung weisen regelmäßig eine vertikale Zwangsführung wie beispielsweise einen in dem Ablaufventil vertikal verlagerbaren Führungsstift auf, sodass durch eine vertikale und zwangsgeführte Verlagerung der Stopfen bzw. die Abdeckung zwischen der Verschlussposition und der Öffnungsposition hin und her bewegt werden können.

Die Betätigung des Stopfens oder der Abdeckung muss in vielen Fällen manuell durchgeführt werden. Dabei kann der Stopfen oder die Abdeckung von einem Benutzer ergriffen und in die gewünschte Position verlagert werden. Zu diesem Zweck kann der Stopfen oder die Abdeckung einen Knauf oder ein Greifelement aufweisen, um von einer Hand ergriffen und verlagert werden zu können. Es sind auch Spülbeckenarmaturen bekannt, die einen außerhalb des Spülbeckens angeordneten herausziehbaren oder verschwenkbaren Hebel aufweisen, der mechanisch mit dem Ablaufventil verbunden ist und mit welchem das Ablaufventil betätigt und wahlweise geöffnet oder verschlossen werden kann. Es sind auch Varianten bekannt, bei denen an oder neben dem Spülbecken ein Betätigungselement wie beispielsweise ein Drehknauf oder eine Drucktaste angeordnet ist und eine manuelle Betätigung des Drehknaufs oder der Drucktaste mechanisch zu dem Ablaufventil übertragen wird und eine durch die manuelle Betätigung vorgegebene Verlagerung des Stopfens oder der Abdeckung bewirken kann. Üblicherweise erfolgt die mechanische Übertragung mit Hilfe eines Hebelgestänges oder eines Bowdenzugs, die jeweils eine mechanische Wirkverbindung zwischen einem manuellen Betätigungselement und dem verlagerbaren Stopfen bzw. der Abdeckung bilden.

Aus der Praxis sind auch elektrisch betätigbare Spülbeckenabläufe bekannt. Die Verlagerung des Stopfens bzw. der Abdeckung wird dabei üblicherweise durch einen Elektromotor bewirkt, der entweder an dem Ablaufventil angeordnet ist oder in einer geeigneten mechanischen Wirkverbindung mit dem Ablaufventil steht. Eine Betätigung des Elektromotors kann auf verschiedene Arten und Weisen bewirkt werden. Es sind Tastschalter oder Wippschalter bekannt, mit denen ein Betrieb des Elektromotors gesteuert werden kann. Es können auch Touchdisplays eingesetzt werden, mit welchen der Betrieb des Elektromotors betätigt und gesteuert werden kann. Aus der Praxis sind weiterhin optische oder kapazitive Näherungssensoren bekannt, mit deren Hilfe eine Annäherung eines Benutzers bzw. einer Hand des Benutzers erfasst werden kann, um dadurch beispielsweise eine Betätigung einer Spülbeckenarmatur oder aber auch eines Spülbeckenablaufs zu steuern.

Bei der Verwendung eines kapazitiven Näherungssensors können bei der bestimmungsgemäßen Nutzung eines Spülbeckens jedoch unerwünschte Beeinträchtigungen durch Wasser und durch Gegenstände auftreten, die sich während der Nutzung in dem Spülbecken oder auf dem Spülbecken befinden oder dort absichtlich oder unabsichtlich angeordnet werden und dadurch die mit dem kapazitiven Näherungssensor erfassten Sensorwerte beeinflussen, sodass gegebenenfalls eine unbeabsichtigte Betätigung des Spülbeckenablaufs ausgelöst wird.

Es wird deshalb als eine Aufgabe der vorliegenden Erfindung angesehen, ein Verfahren zum Betätigen eines elektrisch betriebenen Spülbeckenablaufs so auszugestalten, dass mit einem kapazitiven Sensor eine möglichst zuverlässige und dennoch komfortable Betätigung des Spülbeckenablaufs ermöglicht werden kann.

Diese Aufgabe wird erfindungsgemäß dadurch gelöst, dass in dem Auswerteschritt in einem Auslöseschritt überprüft wird, ob eine erste Veränderung der erfassten Kapazitätskenngröße ein vorgegebenes Auslösekriterium erfüllt, dass in diesem Fall in einem dem Auslöseschritt nachfolgenden Bestätigungsschritt ein erstes Bestätigungszeitfenster vorgegeben wird und überprüft wird, ob innerhalb des ersten Bestätigungszeitfenster eine zweite Veränderung der erfassten Kapazitätskenngröße ein erstes Bestätigungskriterium erfüllt, und dass das Ablaufbetätigungskriterium nur dann erfüllt ist, wenn die innerhalb des ersten Bestätigungszeitfensters erfasste zweite Veränderung der erfassten Kapazitätskenngröße das erste Bestätigungskriterium erfüllt. Durch die Aufteilung des Ablaufbetätigungskriteriums in ein Auslösekriterium und in ein erstes Bestätigungskriterium und durch die Vorgabe des Auslösekriteriums, welches in dem Auslöseschritt überprüft wird und erfüllt sein muss, und die zusätzliche Vorgabe eines ersten Bestätigungskriteriums, welches in dem nachfolgenden Bestätigungsschritt überprüft wird und ebenfalls erfüllt sein muss, kann eine unbeabsichtigte Fehlbetätigung des Spülbeckenablaufs weitgehend verhindert werden, die durch eine Beeinträchtigung des kapazitiven Sensors durch beispielsweise Wassertropfen oder Gegenstände in der unmittelbaren Nähe des kapazitiven Sensors verursacht werden könnte. Das Auslösekriterium und das erste Bestätigungskriterium können übereinstimmende Kriterien enthalten, sodass beispielsweise zwei aufeinanderfolgende, jedoch gleich oder ähnlich ablaufende Annäherungen oder Berührungen einer Sensorfläche des kapazitiven Sensors durch einen Benutzer erforderlich sind, um das Ablaufbetätigungskriterium zu erfüllen und eine Betätigung des den Spülbeckenablaufs auszulösen. Es können auch zwei verschiedene Kriterien vorgegeben werden, sodass beispielsweise eine schnelle Annäherung oder kurze, aber nicht zu kurze Berührung der Sensorfläche das Auslösekriterium erfüllt, während das erste Bestätigungskriterium in einem vorgegebenen zeitlichen Abstand eine langsame Annäherung oder eine etwas längere, aber nicht zu lange Berührung der Sensorfläche des kapazitiven Sensors erfordert, um auch das erste Bestätigungskriterium und damit das Ablaufbetätigungskriterium zu erfüllen. Das erste Bestätigungskriterium kann auch die Bedingung enthalten, dass eine Berührung der Sensorfläche, welche das Auslösekriterium erfüllt, für einen in dem ersten Bestätigungskriterium vorgegebenen Zeitraum beibehalten und danach beendet werden muss, sodass eine ausreichend lange, aber nicht zu lange Berührung der Sensorfläche das Ablaufbetätigungskriterium erfüllt.

Für jedes Kriterium können absolute oder durch Bezugnahme auf eine vorausgegangene Kalibrierung relative Schwellenwerte oder Wertebereiche der Kapazitätskenngrößen vorgegeben werden. Es können auch absolute oder relative Schwellenwerte oder Wertebereiche für eine zeitliche Änderung der Kapazitätskenngrößen vorgegeben werden. Es ist ebenfalls denkbar, dass ein zeitlicher Verlauf der Kapazitätskenngrößen bzw. ein zeitlicher Verlauf der Kapazitätskenngrößen innerhalb eines für den zeitlichen Verlauf vorgegebenen absoluten oder relativen Wertebereichs als Kriterium vorgegeben werden kann. Es ist weiterhin denkbar, dass ein Kriterium oder beide Kriterien, also das Auslösekriterium und das erste Bestätigungskriterium entweder vorab fest vorgegeben sind oder durch einen Benutzer während der Nutzungsdauer verändert bzw. mehrfach und nach Belieben vorgegeben werden können.

Die für die Überprüfung des Ablaufbetätigungskriteriums verwendete Auswerteeinrichtung weist zweckmäßigerweise eine elektronische Kontrolleinrichtung mit einem Mikroprozessor auf und ist derart ausgestaltet und eingerichtet, dass die mit einem kapazitiven Sensor erfassten Sensordaten vorzugsweise digital verarbeitet und ausgewertet werden können. Die Auswerteeinrichtung ist darüber hinaus zweckmäßigerweise auch mit einer Aktivierungseinrichtung oder mit einer Aktoreinrichtung verbunden, mit welcher der elektrisch betriebene Spülbeckenablauf in der gewünschten Weise betätigt werden kann.

Ein wesentlicher Vorteil bei der Verwendung eines kapazitiven Sensors als Betätigungselement für den elektrisch betriebenen Spülbeckenablauf ist neben einer sehr bequemen Handhabung die Möglichkeit, auf einen ansonsten notwendigen zusätzlichen Durchbruch in dem Spülbecken verzichten zu können und auf diese Weise die damit verbundenen Nachteile einer zusätzlich erforderlichen Abdichtung und der unvermeidbaren Kanten und Fugen, an und in denen sich Verunreinigungen ansammeln können, vermeiden zu können. Dadurch werden auch die hygienischen Bedingungen im Bereich des Spülbeckens verbessert und dessen Reinigung erleichtert.

Einer Ausgestaltung des Erfindungsgedankens zufolge kann vorgesehen sein, dass das Auslösekriterium zunächst eine vorgegebene Zunahme der erfassten Kapazitätskenngröße und anschließend eine vorgegebene Abnahme der erfassten Kapazitätskenngröße beinhaltet. Die für die Erfüllung des Auslösekriteriums erforderliche Zunahme und Abnahme der über einen zeitlichen Verlauf hinweg erfassten Kapazitätskenngrößen können entweder durch Schwellenwerte oder durch Wertebereiche vorgegeben werden. Die Zunahme und die Abnahme der Kapazitätskenngrößen kann so vorgegeben werden, dass für eine vorgebbare Auslösezeitdauer die Sensorfläche des kapazitiven Sensors beispielsweise mit einem Finger oder mit der Hand des Benutzers berührt werden muss. Die Auslösezeitdauer kann dabei beispielsweise so vorgegeben werden, dass das Auslösekriterium ein kurzes Antippen oder ein längeres Berühren der Sensorfläche erfordert. Für das erste Bestätigungskriterium kann ein übereinstimmendes Kriterium vorgegeben werden, sodass eine aufeinanderfolgende gleichartige Annäherung oder Berührung der Sensorfläche erforderlich ist, um das Ablaufbetätigungskriterium zu erfüllen. Solche Gesten sind aus der Praxis bekannt und erlauben eine intuitive und gleichzeitig komfortable Betätigung des Spülbeckenablaufs.

Gemäß einem als besonders vorteilhaft erachteten Aspekt des Erfindungsgedankens kann optional vorgesehen sein, dass in dem Auslöseschritt mit einem ersten kapazitiven Sensor die Kapazitätskenngrößen für die Überprüfung der ersten Veränderung der erfassten Kapazitätskenngröße erfasst werden, und dass in dem Bestätigungsschritt mit einem zweiten kapazitiven Sensor die Kapazitätskenngrößen für die Überprüfung der zweiten Veränderung der erfassten Kapazitätskenngröße erfasst werden. Der erste kapazitive Sensor und der zweite kapazitive Sensor können an dem Spülbecken oder in der Nähe des Spülbeckens mit einem ausreichend großen Abstand zueinander angeordnet und festgelegt werden, sodass eine unabsichtliche Annäherung oder Berührung der beiden kapazitiven Sensoren mit demselben Finger oder mit derselben Hand eines Benutzers weitgehend ausgeschlossen werden können. Dabei wird vorausgesetzt, dass die elektrischen Eigenschaften des Spülbeckens die benachbarte Anordnung und den getrennten Betrieb bzw. eine voneinander unabhängige Auswertung von zwei kapazitiven Sensoren ermöglichen. Insbesondere sollte eine Permittivität des Spülbeckens ausreichend gering sein, sodass anhand der mit den zwei kapazitiven Sensoren erfassten Sensorsignale eine Annäherung an oder eine Berührung des ersten kapazitiven Sensors unterschieden werden kann von der Annäherung an oder von der Berührung des zweiten kapazitiven Sensors. Durch die Verwendung von zwei räumlich beabstandet angeordneten kapazitiven Sensoren bestehen zahlreiche Optionen für die Ausgestaltung des Bestätigungsschritts und des darin überprüften Bestätigungskriteriums.

Es kann weiterhin auch vorgesehen sein, dass das erste Bestätigungszeitfenster zeitlich so kurz und kurz andauernd nach dem Auslöseschritt vorgegeben wird, dass das Ablaufbetätigungskriterium im Wesentlichen nur mit zwei Händen eines Benutzers durch eine nahezu gleichzeitige und rasch aufeinanderfolgende Berührung der jeweiligen Sensorfläche der beiden kapazitiven Sensoren erfüllt werden kann. Durch einen ausreichend großen Abstand und eine geeignete Anordnung der beiden kapazitiven Sensoren kann in Verbindung mit einer geeigneten Übermittlung und Auswertung der jeweiligen Sensorsignale zudem weitgehend ausgeschlossen werden, dass durch Wassertropfen oder Wasseransammlungen bzw. durch aufliegende Gegenstände das jeweilige Kriterium für die beiden kapazitiven Sensoren unbeabsichtigt erfüllt werden kann.

Im Hinblick auf eine möglichst zuverlässige Betätigung und das Vermeiden einer unbeabsichtigten Betätigung des Spülbeckenablaufs kann weiterhin optional vorgesehen sein, dass das Auslösekriterium in dem Auslöseschritt eine vorgegebene Zunahme der mit dem ersten kapazitiven Sensor erfassten Kapazitätskenngröße beinhaltet, und dass das erste Bestätigungskriterium in dem Bestätigungsschritt beinhaltet, dass während des Bestätigungsschritts eine vorgegebene Abnahme der mit dem ersten kapazitiven Sensor erfassten Kapazitätskenngröße erfolgt, und dass eine Kombination der mit dem ersten kapazitiven Sensor erfassten Kapazitätskenngröße und der mit dem zweiten kapazitiven Sensor erfassten Kapazitätskenngröße während der Dauer des sich unmittelbar an die Erfüllung des Auslösekriteriums anschließenden ersten Bestätigungszeitfensters innerhalb eines vorgegebenen Kapazitätskenngrößenkombinationsbereichs liegt. Wenn die beiden Sensorflächen der beiden kapazitiven Sensoren ausreichend nahe beieinander bzw. teilweise überlappend angeordnet sind, kann das Ablaufbetätigungskriterium beispielsweise durch eine geeignete Wischgeste erfüllt werden, wobei ein Benutzer mit einem Finger oder mit einer Handfläche zuerst die Sensorfläche des ersten kapazitiven Sensors berührt und dann durch eine Wischbewegung den Finger oder die Handfläche in die Sensorfläche des zweiten kapazitiven Sensors verlagert. Dabei können nicht nur Schwellenwerte oder Wertebereiche für die vorgegebene Kombination der mit den beiden kapazitiven Sensoren erfassten Kapazitätskenngrößen vorgegeben werden, sondern auch Schwellenwerte oder Wertebereiche für einen zeitlichen Verlauf, sodass die Wischgeste beispielsweise innerhalb einer vorgebbaren Wischgestenzeitdauer und damit weder zu rasch noch zu langsam durchgeführt werden muss.

Beispielsweise bei einer Reinigung des Spülbeckens oder bei dem Abwischen von Tropfen oder Flüssigkeitsresten auch Wischgesten durchgeführt werden könnten, die unbeabsichtigt das erste Bestätigungskriterium erfüllen könnten und dann zu einer unerwünschten Betätigung des Spülbeckenablaufs führen würden, kann es zweckmäßig sein, dass das Auslösekriterium so vorgegeben wird, dass beispielsweise ein kurzzeitiges Berühren oder Antippen eines kapazitiven Sensors erforderlich ist, bevor unmittelbar anschließend das erste Bestätigungszeitfenster für die Erfassung einer nachfolgenden Wischgeste freigegeben wird. Es ist auch denkbar, dass in dem Bestätigungsschritt die Wischgeste mit weiteren Kriterien wie beispielsweise zusätzlichen Gesten oder Annäherungen bzw. Berührungen der kapazitiven Sensoren kombiniert wird, um eine unbeabsichtigte Auslösung des Spülbeckenablaufs zu vermeiden. Bei der Verwendung und Anordnung von drei oder mehr kapazitiven Sensoren kann auch anstelle einer linearen Wischgeste eine komplexe Geste vorgegeben werden, die in der vorgegebenen Reihenfolge drei oder mehr kapazitive Sensoren einbezieht.

Die Zuverlässigkeit der Betätigung des Spülbeckenablaufs kann optional dadurch erhöht werden, dass in dem Bestätigungsschritt zusätzlich zu dem ersten Bestätigungszeitfenster ein zeitlich nicht damit überlappendes zweites Bestätigungszeitfenster vorgegeben wird und überprüft wird, ob innerhalb des zweiten Bestätigungszeitfensters eine dritte Veränderung der erfassten Kapazitätskenngröße ein zweites Bestätigungskriterium erfüllt, und dass in dem Bestätigungsschritt das Ablaufbetätigungskriterium nur dann erfüllt ist, wenn die innerhalb des ersten Bestätigungszeitfensters erfasste zweite Veränderung der erfassten Kapazitätskenngrößen das erste Bestätigungskriterium erfüllt und wenn die innerhalb des zweiten Bestätigungszeitfensters erfasste dritte Veränderung der erfassten Kapazitätskenngrößen das zweite Bestätigungskriterium erfüllt. Mit Hilfe des zweiten Bestätigungskriteriums kann auch bei der Verwendung von nur einem einzigen kapazitiven Sensor eine ungewollte oder unabsichtliche Betätigung des Spülbeckenablaufs weitestgehend vermieden werden. Dabei können das erste Bestätigungskriterium und das zweite Bestätigungskriterium im Wesentlichen identisch vorgegeben werden und auch identisch zu dem Auslösekriterium sein, sodass beispielsweise ein dreimaliges Antippen der Sensorfläche des einzigen kapazitiven Sensors das Ablaufbetätigungskriterium erfüllt und die Betätigung des elektrisch betriebenen Spülbeckenablaufs ausgelöst wird.

Es ist ebenfalls möglich und kann die Zuverlässigkeit bei der Betätigung des Spülbeckenablaufs zusätzlich verbessern, wenn für das Auslösekriterium, für das erste Bestätigungskriterium und für das zweite Bestätigungskriterium zwei oder sogar drei verschiedene kapazitive Sensoren verwendet werden, die in der vorgegebenen zeitlichen Abfolge in einer dem jeweiligen Kriterium entsprechenden Art und Weise berührt werden müssen bzw. an welche jeweils eine Annäherung stattfinden muss. Es kann auch vorgesehen sein, dass das erste Bestätigungskriterium und das zweite Bestätigungskriterium unterschiedlich ausgestaltet sind, sodass verschiedene Annäherungen oder Berührungen von entweder demselben kapazitiven Sensor oder von zwei verschiedenen kapazitiven Sensoren erforderlich sind. Auf diese Weise kann eine unerwünschte Beeinflussung bei der Erfassung der Kapazitätskenngrößen und eine daraus resultierende ungewollte oder unbeabsichtigte Betätigung des Spülbeckenablaufs in praktischer Hinsicht vollständig ausgeschlossen werden. Es ist selbstverständlich auch möglich, dass zusätzlich zu dem zweiten Bestätigungskriterium ein drittes Bestätigungskriterium oder noch weitere Bestätigungskriterien hinzugefügt und ebenfalls erfüllt werden müssen, um die Betätigung des Spülbeckenablaufs auszulösen. So könnte beispielsweise auch eine kapazitive Sensoreinrichtung mit einer kapazitiven taktilen Matrix verwendet werden, mit welcher komplexe Gesten oder komplexe räumliche Annäherungs- oder Berührungsmuster erfasst und erkannt werden können.

Um die Auswertung der erfassten Kapazitätskenngrößen zu vereinfachen und möglichst zuverlässig durchführen zu können ist einer Ausgestaltung des Erfindungsgedankens zufolge vorgesehen, dass vor der Durchführung des Auslöseschritts und des Bestätigungsschritts ein Sensorsignalaufbereitungsschritt durchgeführt wird, in welchem die erfassten Kapazitätskenngrößen mit einem Bandpassfilter gefiltert werden. Der Bandpassfilter kann eine elektronische Schaltung mit einem Tiefpassfilter und mit einem Hochpassfilter aufweisen, mit denen Frequenzen oberhalb eines Schwellenwertes des Tiefpassfilters und unterhalb eines Schwellenwertes des Hochpassfilters aus den erfassten Kapazitätskenngrößen herausgefiltert und verworfen werden können. Auf diese Weise können beispielsweise Veränderungen der Kapazitätskenngrößen mit zu geringen Frequenzen, ein statischer Offset oder eine langsame Drift der erfassten Kapazitätskenngrößen mit dem Hochpassfilter herausgefiltert werden. Mit einem in geeigneter Weise eingerichteten Hochpassfilter können auch unerwünschte Beeinflussungen durch beispielsweise auf der Sensorfläche sich ansammelnde Wassermengen oder darauf oder in der Nähe abgestellte Gegenstände herausgefiltert werden. In gleicher Weise können zu hohe Frequenzen der erfassten Kapazitätskenngrößen, wie sie beispielsweise auf Grund von Störungen durch elektromagnetische Felder oder Einstreuungen anderer elektrischer Geräte erfolgen könnten, durch einen in geeigneter Weise eingerichteten Tiefpassfilter herausgefiltert werden. Der anschließend in dem Auswerteschritt erforderliche Aufwand für die Überprüfung der Auslöse- und Bestätigungskriterien kann damit erheblich reduziert und die Auswertung deutlich zuverlässiger vorgenommen werden. Der Bandpassfilter kann auch mit Hilfe einer geeignet programmierten Auswertelogik im Rahmen der Bearbeitung und Auswertung digitaler Werte der Kapazitätskenngrößen realisiert werden.

Für das Verfahren können der eine kapazitive Sensor oder gegebenenfalls die mehreren kapazitiven Sensoren an einem beliebigen geeigneten Ort an dem Spülbecken oder in der Nähe des Spülbeckens angeordnet und festgelegt werden. In vorteilhafter Weise wird bei der Anordnung eines kapazitiven Sensors ein Durchbruch in dem Spülbecken oder in einer angrenzenden Oberfläche vermieden, um den Aufwand für zusätzliche Abdichtungen des betreffenden Durchbruchs vermeiden und eine möglichst einheitliche und ansprechende Oberflächengestaltung zu ermöglichen. Zudem wird durch das Vermeiden von Durchbrüchen oder entsprechenden Fugen und Kanten in dem Spülbecken eine Reinigung des Spülbeckens und die Einhaltung hoher hygienischer Standards erleichtert. In vielen Fällen kann es zweckmäßig sein, dass ein oder mehrere kapazitive Sensoren unter einer an das Spülbecken angrenzenden Arbeitsplatte so angeordnet und festgelegt werden, dass durch eine Berührung eines unmittelbar über dem kapazitiven Sensor befindlichen Bereichs der Arbeitsplatte, welcher die Sensorfläche bildet, eine ausreichende Annäherung an die Sensorfläche bzw. Berührung der Sensorfläche erfolgt, um durch eine entsprechende Veränderung der von dem betreffenden kapazitiven Sensor erfassten Kapazitätskenngrößen die jeweiligen Kriterien erfüllen zu können.

Wenn das Spülbecken aus einem metallischen Material oder aus einem Material hergestellt ist, welches eine für die Verwendung als Messelektrode ausreichend hohe dielektrische Konstante bzw. Permittivität aufweist, kann optional vorgesehen sein, dass in dem Auslöseschritt ein metallisches oder ausreichend dielektrisch leitfähiges Spülbecken als Messelektrode des kapazitiven Sensors verwendet wird, der für die Erfassung der Kapazitätskenngrößen verwendet wird. Auch für den Bestätigungsschritt kann das metallische Spülbecken als Messelektrode für denselben kapazitiven Sensor verwendet werden. In diesem Fall muss lediglich zwei Mal oder drei Mal das metallische Spülbecken in einer durch die jeweiligen Kriterien vorgegebener Art und Weise berührt werden, um den Betrieb des Spülbeckenablaufs auszulösen. Auf diese Weise wird eine besonders komfortable und gleichzeitig zuverlässige Betätigung des elektrisch betriebenen Spülbeckenablaufs ermöglicht. Es kann ebenfalls vorgesehen sein, dass eine metallische Armatur des Spülbeckens oder ein Teil davon als Messelektrode des kapazitiven Sensors verwendet wird.

Die Erfindung betrifft ebenfalls eine Vorrichtung zum Betätigen eines elektrisch betriebenen Spülbeckenablaufs, wobei die Vorrichtung eine Sensoreinrichtung mit mindestens einem kapazitiven Sensor für die Erfassung mindestens einer Kapazitätskenngröße, eine Auswerteeinrichtung für die Auswertung der mit der Sensoreinrichtung erfassten Kapazitätskenngrößen und eine Betätigungseinrichtung für den elektrischen Betrieb des Spülbeckenablaufs aufweist. Die aus der Praxis bekannten Vorrichtungen, die einen kapazitiven Sensor zur Betätigung des elektrisch betriebenen Spülbeckenablaufs aufweisen, sind üblicherweise entweder kompliziert in der Bedienung oder anfällig gegenüber einer Fehlbedienung bzw. einer unbeabsichtigten Auslösung und Betätigung des elektrisch betriebenen Spülbeckenablaufs.

Es wird deshalb als einen weiteren Aspekt der Erfindung angesehen, eine derartige Vorrichtung so auszugestalten, dass eine möglichst komfortable und zuverlässige Betätigung des elektrisch betriebenen Spülbeckenablaufs ermöglicht wird.

Erfindungsgemäß ist vorgesehen, dass die Auswerteeinrichtung dafür geeignet und derart eingerichtet ist, dass mit der Vorrichtung ein erfindungsgemäßes Verfahren zum Betätigen eines elektrisch betriebenen Spülbeckenablaufs durchführbar ist, wie es in den voranstehenden Ausführungen definiert und erläutert ist. Bei dem erfindungsgemäßen Verfahren werden für das Ablaufbetätigungskriterium mindestens zwei Kriterien, nämlich ein Auslösekriterium und mindestens ein ersten Bestätigungskriterium vorgegeben, die beide erfüllt werden müssen, um den Spülbeckenablauf zu betätigen. Das Auslösekriterium und das erste Bestätigungskriterium können jeweils so vorgegeben werden, dass eine unbeabsichtigte Betätigung des Spülbeckenablaufs weitestgehend ausgeschlossen werden kann und eine unerwünschte Beeinträchtigung eines kapazitiven Sensors durch Flüssigkeiten oder Gegenstände, welche sich zeitweilig oder dauerhaft auf oder in der Nähe der Sensorfläche befinden, nicht zu einer Fehlauslösung oder fehlerhaften Betätigung des Spülbeckenablaufs führen.

Gemäß einer als besonders vorteilhaft erachteten Ausgestaltung des Erfindungsgedankens ist vorgesehen, dass die Sensoreinrichtung eine Kontaktiereinrichtung aufweist, mit welcher ein metallisches Spülbecken oder eine metallische Armatur des Spülbeckens elektrisch leitend so kontaktierbar ist, sodass das metallische Spülbecken oder die metallische Armatur eine Messelektrode des kapazitiven Sensors bildet. Anstelle eines metallischen Spülbeckens können auch ein Spülbecken oder eine Armatur aus einem Material oder aus einer Materialkombination mit der Kontaktiereinrichtung kontaktiert und als Messelektrode verwendet werden, deren Permittivität ausreichend hoch ist, um eine bestimmungsgemäße Annäherung oder Berührung des Spülbeckens oder der Armatur zuverlässig erfassen zu können. Auf diese Weise wird es einem Benutzer ermöglicht, durch eine Berührung des beispielsweise metallischen Spülbeckens oder durch eine ausreichende Annäherung an das Spülbecken den elektrisch betriebenen Spülbeckenablauf zu betätigen, wobei die betreffenden Bewegungen jeweils das Auslösekriterium und anschließend zumindest das erste Bestätigungskriterium erfüllen müssen.

Eine sehr einfache Betätigung kann durch eine entsprechende Vorgabe des Auslösekriteriums und des ersten Bestätigungskriteriums beispielsweise dadurch erfolgen, dass ein Benutzer das Spülbecken zweimal in einem vorgegebenen zeitlichen Abstand aufeinanderfolgend antippt, wobei jedes Antippen zwar kurz, jedoch ausreichend lange erfolgen muss, um beispielsweise einen auf das Spülbecken herabfallenden und mehrfach aufprallenden Gegenstand als Auslöser für den Spülbeckenablauf auszuschließen. Eine gesonderte Anordnung und Festlegung eines kapazitiven Sensors bzw. von dessen Messelektrode ist nicht erforderlich. Da die gesamte Oberfläche des metallischen Spülbeckens als Messelektrode des kapazitiven Sensors genutzt wird, ist ein Benutzer nicht auf einen üblicherweise deutlich kleineren Bereich einer Sensorfläche bzw. einer Messelektrode beschränkt und kann eine Betätigung des Spülbeckenablaufs auslösen, solange er lediglich die Oberfläche des Spülbeckens berühren oder sich ausreichend annähern kann. An Stelle eines metallischen Spülbeckens kann auch eine metallische Armatur oder ein Teil der metallischen Armatur als Messelektrode des kapazitiven Sensors verwendet werden, sodass die voranstehenden Ausführungen auch für eine Annäherung bzw. ein Berühren der metallischen Armatur gelten können.

Einer anderen und ebenfalls als vorteilhaft erachteten Ausgestaltung des Erfindungsgedankens zufolge ist vorgesehen, dass die Sensoreinrichtung einen ersten kapazitiven Sensor und einen zweiten kapazitiven Sensor aufweist, die beabstandet voneinander an dem Spülbecken oder in der Nähe des Spülbeckens festlegbar sind. Durch die Verwendung von zwei kapazitiven Sensoren, die in einem Abstand zueinander angeordnet sind, kann die Zuverlässigkeit bei der Betätigung des Spülbeckenablaufs erhöht werden, indem beispielsweise eine zeitliche Abfolge bei der Berührung der jeweiligen Sensorflächen oder unterschiedliche Gesten bei der Berührung der jeweiligen Sensorflächen so vorgegeben werden, dass eine unbeabsichtigte Fehlbedienung oder eine unerwünschte Beeinflussung durch Flüssigkeiten oder Gegenstände, die sich in oder auf dem Spülbecken befinden, weitestgehend ausgeschlossen werden kann.

Optional ist vorgesehen, dass die Vorrichtung einen elektrisch betriebenen Spülbeckenablauf aufweist, und dass die Betätigungseinrichtung an dem elektrisch betriebenen Spülbeckenablauf festlegbar ist. Auf diese Weise kann die Vorrichtung auch als nachrüstbare Einheit angeboten und ohne größeren Aufwand bei bereits installierten Spülbecken integriert werden. Die Vorrichtung weist alle erforderlichen Komponenten auf. Alle Komponenten können zudem mit Ausnahme des mindestens einen kapazitiven Sensors in oder an einem Gehäuse des Spülbeckenablaufs angeordnet und festgelegt sein, sodass lediglich ein geringer Montageaufwand anfällt.

In Abhängigkeit von einer Komplexität der Kriterien kann es zweckmäßig sein, für den mindestens einen kapazitiven Sensor einen handelsüblichen und kostengünstigen Sensor zu verwenden, der nur ein mit geringem Aufwand aufbereitetes Sensorsignal und gegebenenfalls nur ein Binärsignal zur Verfügung stellen kann. Es kann im Hinblick auf eine zuverlässige Bedienung und Betätigung des Spülbeckenablaufs auch vorgesehen sein, dass ein für den jeweiligen Verwendungszweck und die konkret vorgesehene Anordnung in oder an einem Spülbecken angepasster Sensor mit einer integrierten oder extern angeordneten Auswertelogik verwendet wird. Im Hinblick auf eine möglichst zuverlässige und mit geringem Aufwand verbundene Auswertung der mit dem mindestens einen kapazitiven Sensor erfassten Kapazitätskenngrößen kann in vorteilhafter Weise vorgesehen sein, dass die Auswerteeinrichtung einen Bandpassfilter zur Filterung der mit der Sensoreinrichtung erfassten Kapazitätskenngrößen aufweist. Ein geeigneter Bandpassfilter kann aus handelsüblichen Komponenten und üblicherweise aus einer Kombination eines Tiefpassfilters und eines Hochpassfilters zusammengestellt werden. Der Bandpassfilter kann auch mit Hilfe einer in geeigneter Weise programmierten elektronischen Datenverarbeitungseinrichtung bzw. mit einem Mikroprozessor realisiert werden. Mit Hilfe eines geeignet ausgelegten Bandpassfilters können die mit der Sensoreinrichtung erfassten Kapazitätskenngrößen gefiltert und dabei weitgehend solche Kapazitätskenngrößen verworfen und nicht für eine nachfolgende Überprüfung der Kriterien verwendet werden, die keinesfalls für die Erfüllung eines der Kriterien in Frage kommen. Dadurch kann in einfacher Weise der Aufwand für die nachfolgende Auswertung der erfassten Kapazitätskenngrößen erheblich reduziert und die Auswertung schneller und zuverlässiger durchgeführt werden.

Nachfolgend werden einige exemplarische Ausführungsbeispiele näher erläutert, die in den Zeichnungen schematisch dargestellt sind. Es zeigt:
Fig. 1 eine schematische Draufsicht auf ein Spülbecken,
Fig. 2 eine Schnittansicht durch das in Fig. 1 dargestellte Spülbecken längs einer Linie II-II in Fig. 1, wobei eine Vorrichtung zur Betätigung eines elektrisch betriebenen Spülbeckenablaufs unterhalb des Spülbeckens angeordnet ist,
Fig. 3 eine schematische Darstellung eines zeitlichen Verlaufs von Kapazitätskenngrößen, die mit einem kapazitiven Sensor der Vorrichtung erfasst und für die Auslösung der Betätigung des Spülbeckenablaufs ausgewertet werden,
Fig. 4 eine schematische Darstellung eines abweichend zu Fig. 3 ausgestalteten Verlaufs von Kapazitätskenngrößen,
Fig. 5 eine schematische Darstellung eines wiederum abweichend zu den Fig. 3 und 4 ausgestalteten Verlaufs von Kapazitätskenngrößen,
Fig. 6 eine schematische Draufsicht auf ein Spülbecken, welches aus einem Material mit einer ausreichend geringen Permittivität hergestellt ist, wobei zwei beabstandet voneinander unterhalb des Spülbeckens angeordnete und an einer Unterseite des Spülbeckens festgelegte kapazitiven Sensoren durch gestrichelte Linien angedeutet sind,
Fig. 7 eine schematische Darstellung eines zeitlichen Verlaufs der Überlagerung der beiden Kapazitätskenngrößen, die mit den beiden kapazitiven Sensoren gemäß der in Fig. 6 dargestellten Anordnung erfasst werden, und
Fig. 8 eine schematische Darstellung einzelner Komponenten einer elektronischen Auswerteeinrichtung, mit welcher die mit einem kapazitiven Sensor erfassten Kapazitätskenngrößen zunächst von einem Bandpassfilter gefiltert und anschließend einer Überprüfungseinrichtung zugeführt werden, mit welcher überprüft werden kann, ob ein Auslösekriterium oder ein Bestätigungskriterium erfüllt ist.

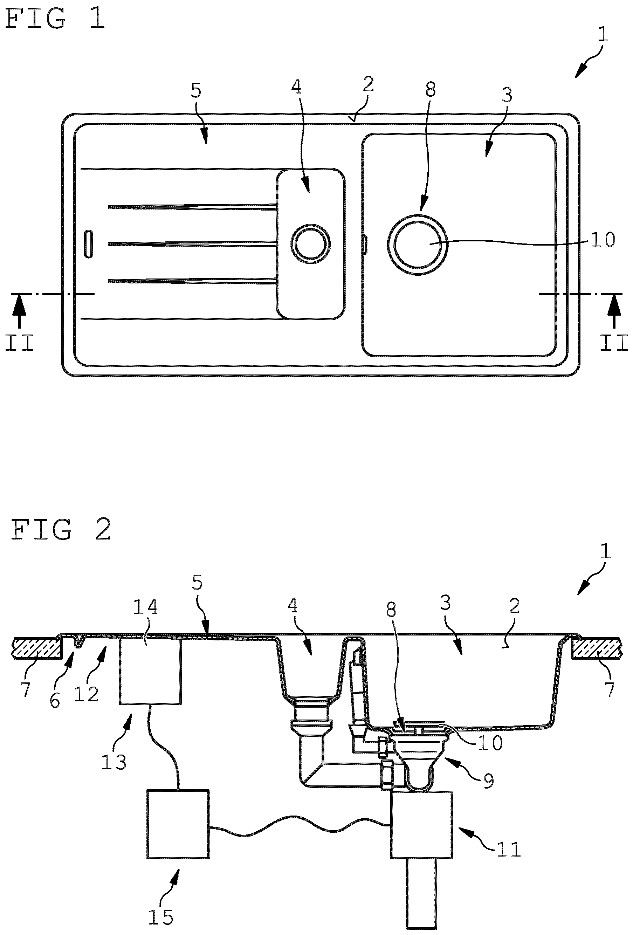

Ein in den Fig. 1 und 2 dargestelltes Spülbecken 1 weist ein Metallblech 2 auf, in welchem ein großes Becken 3 und ein kleineres Becken 4 ausgebildet sind. Neben dem großen Becken 3 und dem kleinen Becken 4 ist eine Ablagefläche 5 ausgebildet. Das Spülbecken 1 ist in eine daran angepasste Aussparung 6 einer nicht näher dargestellten Arbeitsplatte 7 eingesetzt. In dem großen Becken 3 ist eine Abflussöffnung 8 ausgebildet, an welcher ein Ablaufventil 9 mit einem in der Abflussöffnung 8 verlagerbaren Stopfen 10 angeordnet ist. Die Verlagerung des Stopfen 10 zwischen einer Verschlussposition, in welcher der Stopfen 10 die Abflussöffnung 8 des großen Beckens 3 verschließt, und einer Öffnungsposition, in welcher der Stopfen 10 etwas oberhalb der Abflussöffnung 8 gelagert ist und die Abflussöffnung 8 freigibt, wird mit Hilfe einer nicht näher dargestellten elektromotorischen Antriebseinrichtung bewirkt, die zusammen mit dem Ablaufventil 9 und dem verlagerbar gelagerten Stopfen 10 Bestandteile eines elektrisch betriebenen Spülbeckenablaufs 11 sind.

An einer von oberhalb der Arbeitsplatte 7 nicht zugänglichen Unterseite 12 des Spülbeckens 1 ist eine Sensoreinrichtung 13 mit einem kapazitiven Sensor 14 so ausgestaltet und angeordnet, dass das Metallblech 2 des Spülbeckens 1 eine Messelektrode des kapazitiven Sensors 14 bildet. Auf diese Weise kann mit der Sensoreinrichtung 13 jede Berührung des Metallblechs 2 des Spülbeckens 1 erfasst und ein zeitlicher Verlauf von entsprechenden Kapazitätskenngrößen ausgegeben werden. Als Kapazitätskenngröße kann beispielsweise eine Kenngröße für eine Ladungsmenge erfasst werden, die sich in dem elektrisch isoliert in der Arbeitsplatte 7 angeordneten Metallblech 2 des Spülbeckens 1 ansammelt, wobei diese Ladungsmenge durch eine Berührung des Metallblechs 2 mit einem Finger oder mit einer Hand oder mit einem anderen Körperteil eines Benutzers beeinflusst und messbar verändert werden kann. Dabei kann die Eigenschaft ausgenutzt werden, dass durch eine Berührung mit einem Finger oder mit einer Hand die Kapazität eines Schwingkreises verändert wird und sich dadurch die Eigenfrequenz oder auch eine messbare Lade- und Entladezeit des Schwingkreises ändern. Durch die Detektion einer Eigenfrequenz oder der charakteristischen Lade- und Entladezeiten kann auf einen Kapazitätswert zurückgerechnet werden.

Die von der Sensoreinrichtung 13, bzw. von dem kapazitiven Sensor 14 erfassten Kapazitätskenngrößen werden einer Auswerteeinrichtung 15 zugeführt. Die Übertragung der Kapazitätskenngrößen zu der Auswerteeinrichtung 15 und die Übertragung von Steuerbefehlen von der Auswerteeinrichtung 15 zu dem elektrisch betriebenen Spülbeckenablauf 11 kann zweckmäßigerweise kabelgebunden oder auch drahtlos erfolgen. Die Auswerteeinrichtung 15 kann in einem gesonderten Gehäuse angeordnet und an einer beliebigen Position an oder in der Nähe des Spülbeckens 1 gelagert oder festgelegt werden. Zweckmäßigerweise kann die Auswerteeinrichtung 15 in einem gemeinsamen Gehäuse mit dem Spülbeckenablauf 11 angeordnet sein, sodass lediglich die Sensoreinrichtung 13 als gesonderte Komponente der Vorrichtung getrennt von dem Spülbeckenablauf 11 angeordnet ist und positioniert werden kann. Es kann auch vorgesehen sein, dass die Auswerteeinrichtung 15 teilweise oder vollständig in die Sensoreinrichtung 13 bzw. in einen kapazitiven Sensor 14 integriert ist und lediglich ein Betätigungssignal von der Auswerteeinrichtung 15 an den Spülbeckenablauf 11 übermittelt wird.

Mit der Auswerteeinrichtung 15 werden die von der Sensoreinrichtung 13 erfassten Kapazitätskenngrößen ausgewertet. Dabei wird überprüft, ob ein vorgegebenes Ablaufbetätigungskriterium erfüllt ist, um in diesem Fall eine Betätigung des Spülbeckenablaufs 11 auszulösen und je nach aktueller Position des Stopfens 10 den Stopfen 10 mit der elektromotorischen Antriebseinrichtung in die Verschlussposition oder in die Öffnungsposition zu verlagern. Das Ablaufbetätigungskriterium enthält erfindungsgemäß zwei verschiedene Kriterien, nämlich ein Auslösekriterium, welches zuerst erfüllt sein muss, und mindestens ein erstes Bestätigungskriterium, welches anschließend ebenfalls erfüllt sein muss, um das so vorgegebene Ablaufbetätigungskriterium zu erfüllen. Gegebenenfalls können noch weitere Kriterien wie beispielsweise ein zweites Bestätigungskriterium dem Ablaufbetätigungskriterium hinzugefügt werden.

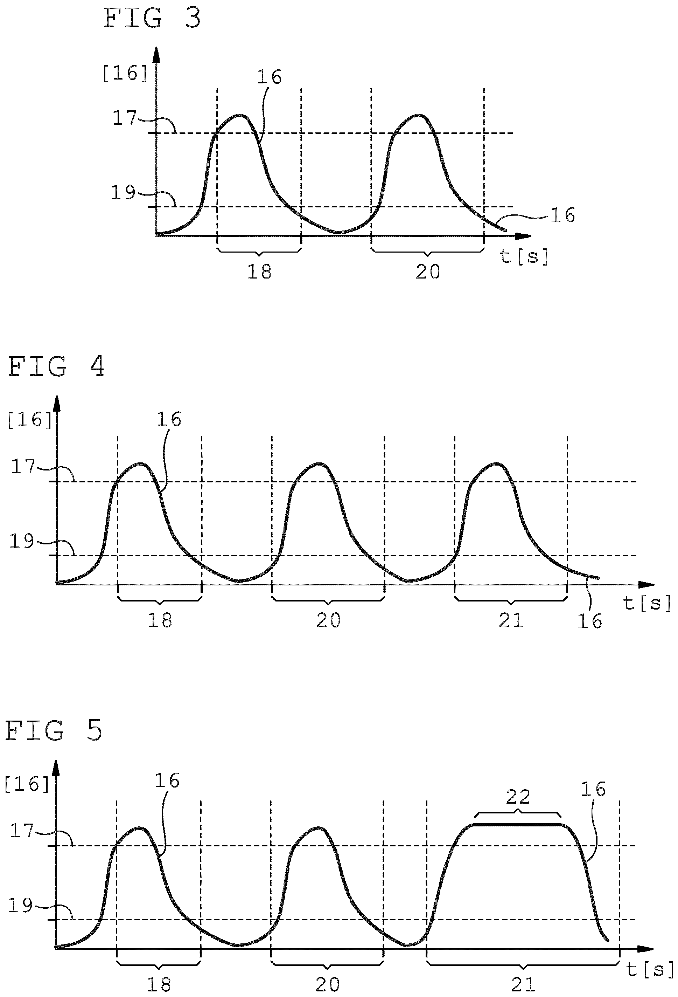

In den Fig. 3 bis 5 sind exemplarisch verschiedene Beispiele für ein jeweils unterschiedlich ausgestaltetes Ablaufbetätigungskriterium dargestellt, wobei jeweils ein zeitlicher Verlauf der Werte der jeweils erfassten Kapazitätskenngrößen 16 dargestellt ist. In allen drei Fällen beinhaltet das Auslösekriterium die Anforderung, dass der Wert der Kapazitätskenngröße 16 einen vorgegebenen Auslöseschwellenwert 17 übersteigen muss und innerhalb eines vorgegebenen ersten Auslösezeitfensters 18 wieder unterhalb eines vorgegebenen Ruheschwellenwerts 19 absinkt. Ist das der Fall, so wie es in allen drei Fig. 3 bis 5 für den jeweils exemplarisch dargestellten zeitlichen Verlauf der erfassten Kapazitätskenngrößen 16 gezeigt ist, wird mit der Auswerteeinrichtung 15 festgestellt, dass das Auslösekriterium erfüllt ist.

Die Erfüllung des Auslösekriteriums triggert die Vorgabe eines ersten Bestätigungszeitfensters 20, innerhalb dessen das erste Bestätigungskriterium erfüllt werden muss. Bei dem in den Fig. 3 bis 5 gezeigten Ausführungsbeispielen beinhaltet das erste Bestätigungskriterium im Wesentlichen identische Vorgaben wie für das Auslösekriterium, sodass das erste Bestätigungskriterium erfüllt ist, wenn der Wert der erfassten Kapazitätskenngröße 16 innerhalb des ersten Bestätigungszeitfensters 20 zunächst wieder über den Auslöseschwellenwert 17 ansteigt und anschließend unter den vorgegebenen Ruheschwellenwert 19 absinkt.

Das in Fig. 3 exemplarisch dargestellte Ablaufbetätigungskriterium umfasst das vorangehend beschrieben Auslösekriterium und das erste Bestätigungskriterium. Der dargestellte zeitliche Verlauf der Werte der erfassten Kapazitätskenngröße 16 erfüllt sowohl das Auslösekriterium als auch das erste Bestätigungskriterium und damit das Ablaufbestätigungskriterium. Der entsprechende zeitliche Verlauf der erfassten Kapazitätskenngröße 16 kann beispielsweise durch ein zweimaliges Antippen des in den Fig. 1 und 2 beispielhaft dargestellten Spülbeckens 1 in einem vorgegebenen zeitlichen Abstand bewirkt werden.

In Fig. 4 ist eine abweichende Variante des Ablaufbetätigungskriteriums gezeigt, welches zusätzlich zu dem ersten Bestätigungskriterium ein weiteres zweites Bestätigungskriterium beinhaltet. Das zweite Bestätigungskriterium enthält dabei für ein zweites Bestätigungszeitfenster 21 identische Vorgaben wie das erste Bestätigungskriterium und damit auch wie das Auslösekriterium. Der in Fig. 4 dargestellte zeitliche Verlauf der Werte der erfassten Kapazitätskenngröße 16 erfüllt die Vorgaben von dem Auslösekriterium ebenso wie die Vorgaben des ersten und des zweiten Bestätigungskriteriums und damit das Ablaufbestätigungskriterium insgesamt. Der entsprechende zeitliche Verlauf der erfassten Kapazitätskenngröße 16 kann beispielsweise durch ein dreimaliges Antippen des in den Fig. 1 und 2 beispielhaft dargestellten Spülbeckens 1 bewirkt werden, wobei für jedes nachfolgende Antippen ein vorgegebener zeitlicher Abstand eingehalten wird.

In Fig. 5 ist lediglich beispielhaft eine weitere und zusätzlich abweichende Variante des Ablaufbetätigungskriteriums gezeigt, welches neben dem ersten Bestätigungskriterium ein zweites Bestätigungskriterium beinhaltet. Das zweite Bestätigungskriterium enthält dabei abweichende Vorgaben wie das erste Bestätigungskriterium und damit auch wie das Auslösekriterium, wobei das zweite Bestätigungszeitfenster 21 länger als das erstes Bestätigungszeitfenster 20 vorgegeben ist und die Werte der erfassten Kapazitätskenngröße 16 mindestens für eine vorgegebene zweite Bestätigungsverweildauer 22 oberhalb des Auslöseschwellenwerts 17 liegen müssen. Der in Fig. 5 dargestellte zeitliche Verlauf der Werte der erfassten Kapazitätskenngröße 16 erfüllt die Vorgaben von dem Auslösekriterium ebenso wie die Vorgaben des ersten und des zweiten Bestätigungskriteriums und damit das Ablaufbestätigungskriterium insgesamt. Der entsprechende zeitliche Verlauf der erfassten Kapazitätskenngröße 16 kann beispielsweise durch ein dreimaliges Antippen des in den Fig. 1 und 2 beispielhaft dargestellten Spülbeckens 1 bewirkt werden, wobei für jedes nachfolgende Antippen ein vorgegebener zeitlicher Abstand eingehalten wird und das dritte Antippen deutlich länger als das erste und zweite Antippen gehalten werden muss.

Durch eine geeignete Vorgabe des Ablaufbestätigungskriteriums kann in einfacher Weise eine sehr zuverlässige Betätigung des elektrisch betriebenen Spülbeckenablaufs 11 durchgeführt werden, wobei eine unabsichtliche Fehlbedienung ebenso wirkungsvoll vermieden werden kann wie eine unerwünschte Betätigung, die durch eine störende Beeinflussung der Sensoreinrichtung 13 wie beispielsweise durch Flüssigkeiten oder Gegenstände ausgelöst werden könnte, die sich zeitweilig an oder in der Nähe der Sensoreinrichtung 13 befinden.

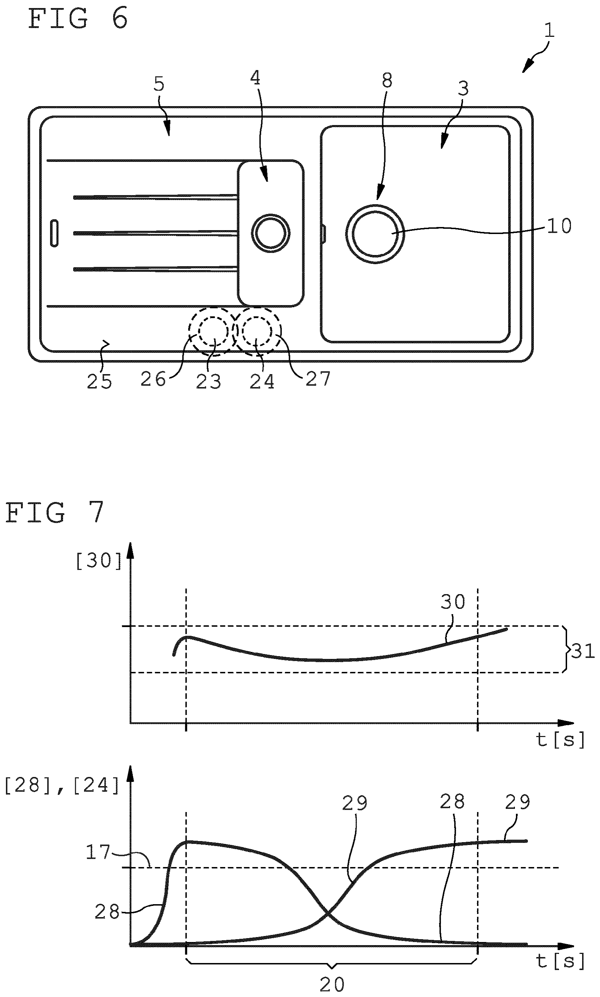

Dabei kann auch vorgesehen sein, dass die in den Fig. 3 bis 5 jeweils als einheitlich erfassten Kapazitätskenngrößen 16 in dem Auslösezeitfenster 18 und in dem ersten Bestätigungszeitfenster 20 sowie gegebenenfalls in dem zweiten Bestätigungszeitfenster 21 von zwei oder drei verschiedenen kapazitiven Sensoren und beispielsweise von zwei kapazitiven Sensoren gemäß einer nachfolgend in den Fig. 6 und 7 gezeigten Anordnung erfasst werden.

In den Fig. 6 und 7 sind exemplarisch eine abweichende Ausgestaltung und Anordnung der Sensoreinrichtung 13 an einem nicht aus Metall hergestellten und deshalb kein Metallblech 2 aufweisenden Spülbecken 1 sowie eine daran angepasste abweichende Vorgabe des Ablaufbetätigungskriteriums dargestellt.

Das beispielsweise aus Keramik hergestellte Spülbecken 1 weist eine ähnliche Formgebung mit einem großen Becken 3, einem kleineren Becken 4 und einer neben dem großen Becken 3 und dem kleinen Becken 4 ausgebildeten Ablagefläche 5 auf. Im Bereich der Ablagefläche 5 sind unterhalb der Ablagefläche 5 beabstandet zueinander zwei in Fig. 6 jeweils mit einer punktierten Linie angedeutete kapazitive Sensoren 23 und 24 mit jeweils einer eigenen Messelektrode so angeordnet und festgelegt, dass auf einer Oberseite 25 der Ablagefläche 5 zwei in Fig. 6 jeweils mit einer gestrichelten Linie angedeutete Sensorflächen 26, 27 gebildet werden, innerhalb der eine Berührung der Ablagefläche 5 durch einen Finger oder durch eine Hand eines Benutzers mit den kapazitiven Sensoren 23 und 24 erfasst werden kann.

Das in Fig. 7 veranschaulichte Ablaufbetätigungskriterium umfasst zunächst ein Auslösekriterium, welches erfüllt ist, sobald die Werte der mit einem der beiden kapazitiven Sensoren 23, 24 erfassten Kapazitätskenngrößen 28, 29 über einen Auslöseschwellenwert 17 ansteigen. Unmittelbar zeitlich anschließend beginnt dann das erste Bestätigungszeitfenster 20, innerhalb dessen der über dem Auslöseschwellenwert 17 angestiegene Wert der Kapazitätskenngröße 28 allmählich abnehmen und der Wert der anderen Kapazitätskenngröße 29 allmählich zunehmen muss, bis der Wert der anderen Kapazitätskenngröße 29 über den Auslöseschwellenwert 17 ansteigt. Dabei muss für den gesamten zeitlichen Verlauf innerhalb des ersten Bestätigungszeitfensters 20 eine als Summe der Werte der beiden erfassten Kapazitätskenngrößen 28, 29 gebildete Kombination 30 der beiden Kapazitätskenngrößen 28, 29 innerhalb eines vorgegebenen Kapazitätskenngrößenkombinationsbereichs 31 bleiben, wie es in Fig. 7 dargestellt ist. Der entsprechende zeitliche Verlauf der erfassten Kapazitätskenngrößen 28, 29 kann beispielsweise durch ein Berühren der ersten Sensorfläche 26 und eine anschließend durchgeführte Wischgeste in die zweite Sensorfläche 27 bewirkt werden, wobei die Wischgeste nicht unterbrochen werden darf und über die Dauer des ersten Bestätigungszeitfensters 20 durchgeführt werden muss. Es kann auch vorgesehen sein, dass das erste Bestätigungskriterium lediglich das ausreichende Ansteigen der mit dem zweiten Kapazitätssensor 24 erfassten anderen Kapazitätskenngröße 29 erfordert und der zeitliche Verlauf der mit dem für das Auslösekriterium verwendeten Kapazitätskenngröße 28 des ersten kapazitiven Sensors 23 nicht mehr berücksichtigt oder ausgewertet wird. Wie bereits beschrieben kann eine solche Wischgeste immer auch mit komplexeren Auslösekriterien oder mit einem zusätzlichen zweiten Bestätigungskriterium kombiniert werden, um eine unbeabsichtigte Fehlauslösung des Spülbeckenablaufs zu vermeiden.

Das in Fig. 7 lediglich beispielhaft dargestellte Ablaufbetätigungskriterium setzt die Verwendung von zwei beabstandet zueinander angeordneten kapazitiven Sensoren 23, 24 voraus. Eine derartige Ausgestaltung der Sensoreinrichtung 13 mit zwei oder mehr verschiedenen kapazitiven Sensoren kann auch für alle anderen Ablaufbetätigungskriterien verwendet werden und beispielsweise dazu führen, dass das Auslösekriterium und das erste Bestätigungskriterium bei den in den Fig. 3 bis 5 dargestellten Ausführungsbeispielen jeweils durch von unterschiedlichen kapazitiven Sensoren erfasste Kapazitätskenngrößen erfüllt werden muss.

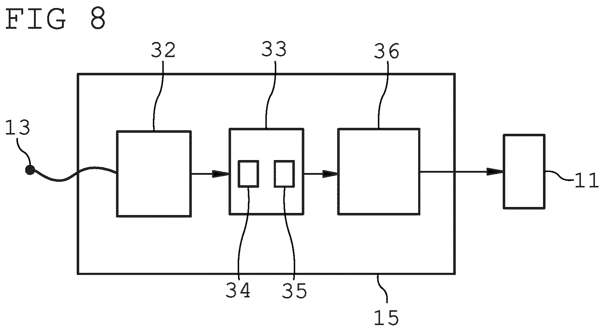

In Fig. 8 ist schematisch eine Ausgestaltung der elektronischen Auswerteeinrichtung 15 dargestellt. Die von der Sensoreinrichtung 13 erfassten Kapazitätskenngrößen 16, 28, 29 werden an die Auswerteeinrichtung 15 übermittelt. Die erfassten Kapazitätskenngrößen 16, 28, 29 werden mit einem Digitalwandler 32 in digitale Werte umgewandelt, die einer Bandpassfiltereinrichtung 33 mit einem Tiefpassfilter 34 und einem Hochpassfilter 35 zugeführt werden. Die mit der Bandpassfiltereinrichtung gefilterten digitalen Werte werden in einer Prüfeinrichtung 36 daraufhin überprüft, ob das Ablaufbetätigungskriterium erfüllt ist. Falls die Überprüfung ergibt, dass das vorgegebene Ablaufbetätigungskriterium erfüllt ist, wird ein entsprechendes Betätigungssignal an den elektrisch betriebenen Spülbeckenablauf 11 übermittelt. Durch die vorausgehende Filterung der digitalen Werte der erfassten Kapazitätskenngrößen 16, 28, 29 können viele Vorgaben des Ablaufbetätigungskriteriums in einfacher Weise überprüft und rasch ausgewertet werden.

## Patentansprüche

1. Verfahren zum Betätigen eines elektrisch betriebenen Spülbeckenablaufs (11), wobei in einem Auswerteschritt mit einem kapazitiven Sensor (14, 23, 24) mehrfach nacheinander Kapazitätskenngrößen (16, 28, 29) erfasst werden und mit einer Auswerteeinrichtung überprüft wird, ob die erfassten Kapazitätskenngrößen (16, 28, 29) ein vorgegebenes Ablaufbetätigungskriterium erfüllen, um anschließend bei einem erfüllten Ablaufbetätigungskriterium in einem Betätigungsschritt eine Betätigung des elektrisch betriebenen Spülbeckenablaufs (11) durchzuführen, **dadurch gekennzeichnet, dass** in dem Auswerteschritt in einem Auslöseschritt überprüft wird, ob eine erste Veränderung der erfassten Kapazitätskenngröße (16, 28, 29) ein vorgegebenes Auslösekriterium erfüllt, dass in diesem Fall in einem dem Auslöseschritt nachfolgenden Bestätigungsschritt ein erstes Bestätigungszeitfenster (20) vorgegeben wird und überprüft wird, ob innerhalb des ersten Bestätigungszeitfensters (20) eine zweite Veränderung der erfassten Kapazitätskenngröße (16, 28, 29) ein erstes Bestätigungskriterium erfüllt, und dass das Ablaufbetätigungskriterium nur dann erfüllt ist, wenn die innerhalb des ersten Bestätigungszeitfensters (20) erfasste zweite Veränderung der erfassten Kapazitätskenngröße (16, 28, 29) das erste Bestätigungskriterium erfüllt.

2. Verfahren nach Anspruch 1, **dadurch gekennzeichnet, dass** das Auslösekriterium zunächst eine vorgegebene Zunahme der erfassten Kapazitätskenngröße (16, 28, 29) und anschließend eine vorgegebene Abnahme der erfassten Kapazitätskenngröße (16, 28, 29) innerhalb eines vorgegebenen Auslösezeitfensters (18) beinhaltet.

3. Verfahren nach Anspruch 1 oder Anspruch 2, **dadurch gekennzeichnet, dass** in dem Auslöseschritt mit einem ersten kapazitiven Sensor (23) die Kapazitätskenngrößen (28) für die Überprüfung der ersten Veränderung der erfassten Kapazitätskenngrößen (28, 29) erfasst werden, und dass in dem Bestätigungsschritt mit einem zweiten kapazitiven Sensor (24) die Kapazitätskenngrößen (29) für die Überprüfung der zweiten Veränderung der erfassten Kapazitätskenngrößen (28, 29) erfasst werden.

4. Verfahren nach Anspruch 3, **dadurch gekennzeichnet, dass** das Auslösekriterium in dem Auslöseschritt eine vorgegebene Zunahme der mit dem ersten kapazitiven Sensor (23) erfassten Kapazitätskenngröße (28) beinhaltet, und dass das erste Bestätigungskriterium in dem Bestätigungsschritt beinhaltet, dass während des Bestätigungsschritts eine vorgegebene Abnahme der mit dem ersten kapazitiven Sensor (23) erfassten Kapazitätskenngröße (28) erfolgt, und dass eine Kombination der mit dem ersten kapazitiven Sensor (23) erfassten Kapazitätskenngröße (28) und der mit dem zweiten kapazitiven Sensor (24) erfassten Kapazitätskenngröße (29) während der Dauer des sich unmittelbar an die Erfüllung des Auslösekriteriums anschließenden ersten Bestätigungszeitfensters (20) innerhalb eines vorgegebenen Kapazitätskenngrößenkombinationsbereichs (31) liegt.

5. Verfahren nach Anspruch 1, **dadurch gekennzeichnet, dass** in dem Bestätigungsschritt zusätzlich zu dem ersten Bestätigungszeitfenster (20) ein zeitlich nicht damit überlappendes zweiten Bestätigungszeitfenster (21) vorgegeben wird und überprüft wird, ob innerhalb des zweiten Bestätigungszeitfensters (21) eine dritte Veränderung der erfassten Kapazitätskenngröße (16, 28, 29) ein zweites Bestätigungskriterium erfüllt, und dass in dem Bestätigungsschritt das Ablaufbetätigungskriterium nur dann erfüllt ist, wenn die innerhalb des ersten Bestätigungszeitfensters (20) erfasste zweite Veränderung der erfassten Kapazitätskenngrößen (16, 28, 29) das erste Bestätigungskriterium erfüllt und wenn die innerhalb des zweiten Bestätigungszeitfensters (21) erfasste dritte Veränderung der erfassten Kapazitätskenngrößen (16, 28, 29) das zweite Bestätigungskriterium erfüllt.

6. Verfahren nach einem der voranstehenden Ansprüche, **dadurch gekennzeichnet, dass** vor der Durchführung des Auslöseschritts und des Bestätigungsschritts ein Sensorsignalaufbereitungsschritt durchgeführt wird, in welchem die erfassten Kapazitätskenngrößen (16, 28, 29) mit einem Bandpassfilter (33) gefiltert werden.

7. Verfahren nach einem der voranstehenden Ansprüche, **dadurch gekennzeichnet, dass** in dem Auslöseschritt ein metallisches Spülbecken (1) oder eine metallische Armatur des Spülbeckens (1) als Messelektrode des kapazitiven Sensors (14) verwendet wird, der für die Erfassung der Kapazitätskenngrößen (16) verwendet wird.

8. Vorrichtung zum Betätigen eines elektrisch betriebenen Spülbeckenablaufs (11), wobei die Vorrichtung eine Sensoreinrichtung (13) mit mindestens einem kapazitiven Sensor (14, 23, 24) für die Erfassung mindestens einer Kapazitätskenngröße (16, 28, 29), eine Auswerteeinrichtung (15) für die Auswertung der mit der Sensoreinrichtung (13) erfassten Kapazitätskenngrößen (16, 28, 29) und eine Betätigungseinrichtung für den elektrischen Betrieb des Spülbeckenablaufs (11) aufweist, **dadurch gekennzeichnet, dass** die Auswerteeinrichtung (15) dafür geeignet und derart eingerichtet ist, dass mit der Vorrichtung ein Verfahren zum Betätigen eines elektrisch betriebenen Spülbeckenablaufs (11) nach einem der Ansprüche 1 bis 7 durchführbar ist.

9. Vorrichtung nach Anspruch 8, **dadurch gekennzeichnet, dass** die Sensoreinrichtung (13) eine Kontaktiereinrichtung aufweist, mit welcher ein metallisches Spülbecken (1) oder eine metallische Armatur des Spülbeckens (1) elektrisch leitend so kontaktierbar ist, sodass das metallische Spülbecken (1) eine Messelektrode des kapazitiven Sensors (14) bildet.

10. Vorrichtung nach Anspruch 8 oder Anspruch 9, **dadurch gekennzeichnet, dass** die Sensoreinrichtung (13) einen ersten kapazitiven Sensor (23) und einen zweiten kapazitiven Sensor (24) aufweist, die beabstandet voneinander an dem Spülbecken (1) oder in der Nähe des Spülbeckens (1) festlegbar sind.

11. Vorrichtung nach einem der Ansprüche 8 bis 10, **dadurch gekennzeichnet, dass** die Vorrichtung einen elektrisch betriebenen Spülbeckenablauf (11) aufweist, und dass die Betätigungseinrichtung an dem elektrisch betriebenen Spülbeckenablauf (11) festlegbar ist.

12. Vorrichtung nach einem der Ansprüche 8 bis 11, **dadurch gekennzeichnet, dass** die Auswerteeinrichtung (15) einen Bandpassfilter (33) zur Filterung der mit der Sensoreinrichtung (13) erfassten Kapazitätskenngrößen (16, 28, 29) aufweist.
